# EUROPEAN PATENT APPLICATION

(11) **EP 1 300 883 A2**
(43) Date of publication of application: **09.04.2003**
(21) Application number: 02078768.5
(22) Date of filing: 13.09.2002
(51) Int. Cl.: H01L 23/373

(54) **Thermal dissipation assembly for electronic components**

(30) Priority: 04.10.2001 US 970180
(71) Applicant: Delphi Technologies, Inc., Troy, MI 48007 (US)
(72) Inventor: Kataria, Vijay, Kokomo, IN 46902 (US)
(74) Representative: Denton, Michael John

(57) **Abstract**

An electrical assembly 10 is providing, including a heat sink case 14, a heat generating component 12, a gap 16 defined between the heat generating component 12 and the heat sink 14, a thermally conductive adhesive 18 positioned within the gap16 including a plurality of physical barrier elements 20 positioned within said thermally conductive adhesive 18, and at least one spacer strip 26 positioned within at least a portion of the gap 16 to reduce damage to the heat generating component 12 cause by the physical barrier elements 20.

## Description

### Technical Field

The present invention relates generally to a thermal dissipation assembly for use as part of an electronics assembly and more particularly to a thermal dissipation assembly with improved resistance to electrical shorts.

### Background of the Invention

Electronic assemblies are designed in a wide variety of configurations for a wide variety of individual applications. It is common for these electronic assemblies, however, to include electronic components that generate heat during operation. Although this generated heat may be acceptable in certain assemblies and applications, in others this generated heat poses a danger to the electronic assembly. Generated heat my result in damage to the electronic component, surrounding components, or the electronic assembly as a whole. In addition, many electronics components fail to operate properly if their temperatures are not kept within a predetermined range. It is therefore, usually highly desirable to dissipate heat generated within the electronics assembly.

One standard approach to the dissipation of heat generated within the electronic assembly is through the use of heat sink components. Heat sink components are well known in the prior art and may take on a variety of forms, including cases, heat rail brackets, and a host of other embodiments. The heat sink component allows heat generated by electronic components to pass into the heat sink and thereby allow the heat generating electronic components to remain at a safe temperature. The heat sink component must remain in sufficient thermal contact with the heat generating electronic component in order to properly dissipate the electronic component's heat. Although the heat sink component must retain sufficient thermal contact, in many applications it must also retain electrical separation from the electronic components. If electrical separation is not maintained, electrical shorts and failure of the electronics assembly may occur. The existence of electrical shorts is known to result in decreased customer satisfaction, increased scrap costs, poor product performance, and increase warranty costs.

One successful method of providing thermal communication while retaining electrical separation has been through the use of thermally conductive adhesives. By filling the gap between a heat generating electronics component and the heat sink with thermally conductive adhesive, heat is allowed to pass from the electronics component into the heat sink. In addition, thermally conductive adhesives are commonly not electrically conductive and therefore can be used to provide the electrical separation between the heat generating electronics component and the heat sink. Although thermally conductive adhesives may be non-conductive and therefore provide electrical separation between the electronics component and the heat sink, often the thermally conductive adhesives do not provide the physical barrier necessary to separate the electronics component from the heat components until the thermally conductive adhesive is cured. As an example, when the substrate of an electronics assembly is mounted to the heat sink, the heat generating electronics component may be pressed towards the heat sink due to the clamping forces created between the substrate and the heat sink. This can still cause the electronics component to penetrate the thermally conductive adhesive and come in contact with the heat sink components during assembly. As has been discussed, contact between the electronics component and the heat sink can result in electrical shorts and other undesirable results. A solution to prevent such penetration would be desirable.

One solution, found in the prior art, to providing the required physical separation while using thermally conductive adhesives has been to introduce glass beads into the thermally conductive adhesive. The glass beads, commonly distributed randomly in the adhesive, are used as a physical separator between the electronics component and the heat sink component in order to reduce penetration of the electronics component through the adhesive. Although glass beads have been developed to reduce in incidents of electrical shorts, ironically they may actually cause such faults in certain situations. Often as portions of electronics assembly are mounted to the heat sink (or experience other assembly processes) the gap between the electronics component and the heat sink experience clamping forces. These clamping forces can force the glass beads during manufacturing to penetrate the soft heat conducting surfaces of the electronics component or heat sink. When these glass beads penetrate, they can push out the metal around them, and thereby cause an electrical short between the electronics component and the heat sink surface or even an electrical short within the electronics component itself. This may not only cause the assembly to malfunction, but it may also result in precisely the same undesirable result that the glass beads were originally designed to avoid. Although this scenario may be avoided by precise control of the clamping forces or improved control of spacing tolerances, this is often not practical due to the variation in thicknesses of electronic components from various manufacturers. The variation in thickness of various electronic components can require adjustments in assembly tolerances and forces that are impractical or costly to implement. Implementing such precise control over the clamping forces may result in undesirable increases in complexity, cost, and assembly time.

It would, therefore, be highly desirable to have a thermal dissipation assembly that provided the benefits of thermally conductive adhesives, that provided adequate physical separation between the electronics component and the heat sink components, and that had a reduced sensitivity to clamping forces during assembly.

### Summary of the Invention

It is, therefore, an object of the present invention to provide a thermal dissipation assembly for use with an electronics assembly that provides thermal dissipation between an electronic component and a heat sink while providing adequate electrical and physical separation between the two components. It is a further object of the present invention to provide a thermal dissipation assembly with reduced sensitivity to assembly clamping forces.

In accordance with the objects of the present invention, an electronics assembly is provided including a heat generating component and a heat sink positioned in relation with one another to form a gap. A thermally conductive material, having a pre-cured state and a cured state, is positioned within the gap such that heat may be dissipated from the heat generating component, through the thermally conductive material, and into the heat sink. Physical barrier elements are positioned within the thermally conductive material to create a physical barrier between the heat generating component and the heat sink. A spacer strip is positioned within at least a portion of the gap to reduce damage to the heat generating component from the physical barrier elements.

Other objects and features of the present invention will become apparent when viewed in light of the detailed description of the preferred embodiment when taken in conjunction with the attached drawings and appended claims.

### Brief Description of the Drawings

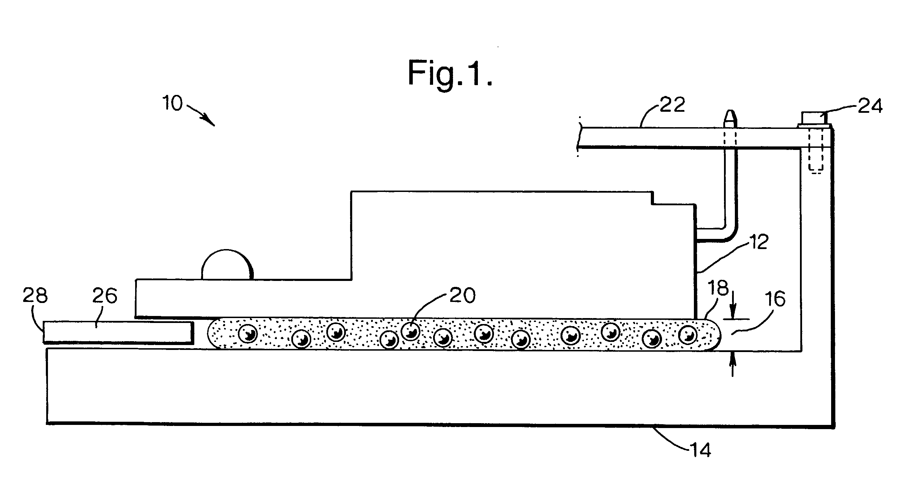

FIGURE 1 is a cross-sectional illustration of one embodiment of an electronics assembly with thermally conductive element in accordance with the present invention;

### Description of the Preferred Embodiment(s)

Referring now to Figure 1, which is an illustration of an electronics assembly 10 in accordance with the present invention. The electronics assembly 10 includes a heat generating component 12 and a heat sink 14. In one embodiment, the heat generating component 12 is an electronic component that generates heat during operation, although a variety of heat generating components 12 are contemplated. Similarly, a wide variety of heat sinks 14 are known in the prior art and contemplated by the present invention. Heat sinks 14 may take the form of metal cases, heat rail components, fins, or a variety of well known configurations. The embodiment illustrated in Figure 1 shows a heat sink 14 in the form of a case. When the electronics assembly 10 is assembled, the heat generating component 12 and the heat sink 14 are positioned to form a gap 16. The gap 16 is filled with a thermally conductive material 18 such as a thermally conductive adhesive. The use of such thermally conductive materials 18 is known in the prior art. These materials are used to facilitate thermal transfer from the heat generating component 12 and the heat sink 14 while allowing the components to remain in electrical isolation from one another.

Although the thermally conductive materials 18 are often used, they often are applied to the gap 16 in a pre-cured state and are then cured to form a solid bond between the heat generating component 12 and the heat sink 14. During assembly of the electronics assembly 10, however, it is possible for the heat generating component 12 to be pressed through the thermally conductive material 18 and into contact with the heat sink 14. In order to prevent this, it is known that physical barrier elements 20 such as glass beads may be placed within the thermally conductive material 18. These physical barrier elements 20 act to provide a minimum distance between the heat generating component 12 and the heat sink 14. Although the physical barrier elements 20 may be formed from a variety of materials and take on a variety of forms, in one embodiment it is contemplated that the physical barrier elements 20 are glass beads. The use of physical barrier elements 20 insures physical separation between the heat generating component 12 and the heat sink 14.

Although the use of physical barrier elements 20 positioned randomly within the thermally conductive material 18 may insure physical separation, their use alone can present problems during assembly of the electronics assembly 10. The heat generating component 12 is commonly mounted to a substrate 22 such as a circuit board. When the substrate 22 is mounted into the larger electronics assembly 10, clamping forces may work to push the heat generating component 12 towards the heat sink 14. One example is shown in Figure 1. When the substrate 22 is mounted to the heat sink 14 (in this example a case), as the mounting points 24 or screws are tightened down a clamping force may arise between the heat generating component 12 and the heat sink 14. These clamping forces may cause the physical barrier elements 20 to damage the heat generating component 12 causing it to malfunction. The present invention reduces damage caused by the physical barrier elements 20 within the thermally conductive material 18 by further including a spacer strip 26 positioned within at least a portion of the gap 16. The spacer strip 26 prevents at least a portion of the clamping forces from being exerted on the physical barrier elements 20.

Although the spacer strip 26 may take on a variety of forms, in one embodiment the spacer strip 26 has a material thickness 28 greater than that of the physical barrier element thickness 30. In another embodiment, the spacer strip 26 is a SIL pad. Although the spacer strip 26 need only be positioned within a small portion of the gap 16 and therefore need not significantly impact the thermal transfer through the thermally conductive material 18, in one embodiment the spacer strip 26 is itself thermally conductive and thereby also acts to transfer heat from the heat generating component 12 to the heat sink 14. In addition, although the spacer strip 26 is illustrated in contact with only a first edge 30 of the heat generating component 12, in alternate embodiments, the spacer strip 26 may be in contact with a plurality of edges of the heat generating component 12. The use of a spacer strip 26 in conjunction with the thermally conductive material 18, allows the present invention to provide adequate thermal transfer, electrical isolation, and a non-damaging physical barrier between the heat generating component 12 and the heat sink 14.

While particular embodiments of the invention have been shown and described, numerous variations and alternative embodiments will occur to those skilled in the arm. Accordingly, it is intended that the invention be limited only in terms of the appended claims.

## Claims

1. An electronics assembly 10 comprising:
a heat generating component 12;
a heat sink 14 positioned to define a gap 16 between said heat generating component and said heat sink 14;
a thermally conductive material 10, having a pre-cured and a cured state, positioned within said gap 16;
a plurality of physical barrier elements 20 positioned within said thermally conductive material 18; and
at least one spacer element 26 positioned within at least a portion of said gap 16, said at least one spacer element 26 preventing said physical barrier elements 20 from damaging said heat generating component 12.

2. An electronics assembly 10 as described in claim 1 wherein said heat generating component 12 is an electronics component.

3. An electronics assembly 10 as described in claim 1 wherein said heat sink 14 is a metal case.

4. An electronics assembly 10 as described in claim 1 wherein said heat sink 14 is a heat rail.

5. An electronics assembly 10 as described in claim 1 wherein said thermally conductive material 18 is a thermally conductive adhesive.

6. An electronics assembly 10 as described in claim 1, wherein said plurality of physical barrier elements 20 includes glass beads.

7. An electronics assembly 10 as described in claim 6, wherein said glass beads 20 are positioned randomly within said thermally conductive material 18.

8. An electronics assembly 10 as described in claim 1 wherein said spacer element 26 is thermally conductive.

9. An electronics assembly 10 as described in claim 1 wherein said spacer element 6 is a SILS pad.

10. An electronics assembly 10 as described in claim 1 wherein said spacer element 26 is in contact with a single edge of said heat generating component 14.

11. An electronics assembly 10 comprising:
a heat sink case 14;
a heat generating component 12 mounted to a substrate 22, said substrate 22 mounted to said heat sink case 14 such that a gap 16 is defined between said heat generating component 12 and said heat sink case 14;
a thermally conductive adhesive 18 positioned within said gap 16; a plurality of physical barrier elements 20 positioned within said thermally conductive adhesive 18; and
at least one spacer element 26 positioned within at least a portion of said gap 16, said at least one spacer element 26 reducing damage to said heat generating component 12 from said physical barrier elements 20.

12. An electronics assembly 10 as described in claim 11 wherein said heat generating component 12 is an electronics component.

13. An electronics assembly 10 as described in claim 11 wherein said plurality of physical barrier elements 20 includes glass beads.

14. An electronics assembly 10 as described in claim 13 wherein said glass beads 20 are positioned randomly within said thermally conductive adhesive 18.

15. An electronics assembly 10 as described in claim 11 wherein said spacer element 26 is thermally conductive.

16. An electronics assembly 10 as described in claim 11 wherein said spacer element 26 is in contact with a single edge of said heat generating component 12.

17. A method of thermally mounting a heat generating component 12 to a heat sink 14 comprising:
placing a spacer element 26 in only a portion of the gap 16 defined between the heat generating component 12 and the heat sink 14;
filling said gap 16 with a thermally conductive adhesive 18 having physical barrier elements 20 positioned randomly within said thermally conductive adhesive 18; and
curing said thermally conductive adhesive 18.

18. A method as described in claim 17 wherein said physical barrier elements 20 include a plurality of glass beads.

19. A method as described in claim 18 wherein said spacer element 26 is thermally conductive

20. A method as described in claim 17 wherein said spacer element 26 is placed in contact with a single edge of said heat generating component 12.
